(19) **Europäisches Patentamt European Patent Office Office européen des brevets**

(11) **EP 2 979 864 B1**

(12) **EUROPEAN PATENT SPECIFICATION**

(45) Date of publication and mention of the grant of the patent:
**14.10.2020 Bulletin 2020/42**

(21) Application number: **14776342.9**

(22) Date of filing: **27.03.2014**

(51) Int Cl.:
**B32B 27/20** (2006.01)   **B32B 27/00** (2006.01)
**H01L 21/301** (2006.01)   **H01L 23/00** (2006.01)
**H01L 23/29** (2006.01)   **H01L 21/683** (2006.01)
**H01L 23/31** (2006.01)   **H01L 23/544** (2006.01)
**C08K 3/38** (2006.01)

(86) International application number:
**PCT/JP2014/058868**

(87) International publication number:
**WO 2014/157520 (02.10.2014 Gazette 2014/40)**

(54) **PROTECTIVE FILM FORMATION COMPOSITE SHEET AND METHOD FOR FABRICATING A CHIP EQUIPPED WITH A PROTECTIVE FILM**

SCHUTZFILMBILDENDE VERBUNDFOLIE UND VERFAHREN ZUR HERSTELLUNG EINES CHIPS MIT SCHUTZFILM

FEUILLE COMPOSITE DE FORMATION DE FILM PROTECTEUR ET PROCÉDÉ DE FABRICATION D'UNE PUCE ÉQUIPÉE D'UN FILM PROTECTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.03.2013 JP 2013070295**

(43) Date of publication of application:
**03.02.2016 Bulletin 2016/05**

(73) Proprietor: **LINTEC Corporation**
**Tokyo 173-0001 (JP)**

(72) Inventors:
• **YAMAMOTO, Daisuke**
**Tokyo 173-0001 (JP)**
• **AZUMA, Yuichiro**
**Tokyo 173-0001 (JP)**

(74) Representative: **Gille Hrabal**
**Brucknerstrasse 20**
**40593 Düsseldorf (DE)**

(56) References cited:
**EP-A1- 2 927 951      EP-A1- 2 980 835**
**JP-A- 2006 140 348    JP-A- 2011 228 451**
**JP-A- 2012 033 638    JP-A- 2012 158 653**
**US-A1- 2011 254 176   US-A1- 2012 025 399**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a composite sheet for forming a protective film that can form a protective film on a back surface of a workpiece such as a semiconductor wafer and a semiconductor chip and can improve the fabricating efficiency of semiconductor chips, a chip with protective film comprising the composite sheet, and a method for fabricating the chip with protective film.

BACKGROUND ART

These days, the fabricating of a semiconductor device using a mounting method of what is called the face-down system is performed. In the face-down system, a semiconductor chip (hereinafter, occasionally simply referred to as a "chip") having electrodes such as bumps on a circuit surface is used, and the electrodes are joined to a substrate. Hence, there is a case where the surface on the opposite side to the circuit surface of the chip (the back surface of the chip) is exposed.

The exposed back surface of the chip may be protected by a protective film formed of an organic film, and may be incorporated into a semiconductor device as a chip with protective film.

In general, the chip with protective film may be obtained by applying a liquid resin to a back surface of a wafer by the spin coating method to form a coating film, drying and curing the coating film to form a protective film on the back surface of the wafer, and cutting the wafer with protective film.

However, since the protective film formed of the liquid resin is not sufficient in thickness accuracy, the reduction in yield of chips with protective film obtained is a problem in many cases.

As a material that can form a protective film with good thickness accuracy, for example, Patent Document 1 discloses a sheet for forming a protective film having a layer for forming a protective film made of at least one of a thermosetting component and an energy ray curable component and a binder polymer component.

With the densification of a semiconductor device installed with a semiconductor chip and the speeding-up of the fabricating process of the semiconductor device in recent years, the heat generation from the semiconductor device is becoming a problem. There are problems that the heat generation of the semiconductor device causes a deformation, trouble, or breakage of the semiconductor device or causes a reduction in computing speed or a malfunction of the semiconductor device, and this leads to a reduction in the reliability of the semiconductor device etc. Thus, good heat dissipation properties are required for semiconductor chips incorporated into high performance semiconductor devices.

For the protective film used for semiconductor chips, also good adhesiveness with an adherend such as copper foil serving as materials for circuit formation, a resist and a workpiece is required.

The protective film formed of the sheet for forming a protective film disclosed in Patent Document 1 is still insufficient in heat dissipation properties and adhesiveness with an adherend such as a workpiece.

As a material for forming a protective film with improved heat dissipation properties, the present applicant proposes a sheet for forming a protective film for chips having a release sheet and a layer for forming a protective film formed on the release sheet, in which the layer for forming a protective film contains a binder polymer component, a curable component, and a metal compound as an inorganic filler and the thermal conductivity of the layer for forming a protective film is 0.5 to 8.0 W/m·K (see Patent Document 2).

The metal compound blended as an inorganic filler in the layer for forming a protective film of the sheet for forming a protective film for chips plays the role of improving the thermal conductivity of a protective film formed by curing the layer for forming a protective film. The sheet for forming a protective film for chips is one that can form a protective film with high uniformity and good thermal conductivity on the back surface of the chip easily.

PRIOR ART

PATENT DOCUMENTS

Patent Document 1: JP 2002-280329A
Patent Document 2: JP 2012-158653A
Patent Document 3: US 2012/025399A1

## SUMMARY OF THE INVENTION

### PROBLEMS TO BE SOLVED BY THE INVENTION

However, in the protective film formed by curing the layer for forming a protective film of the sheet for forming a protective film for chips disclosed in Patent Document 2, the gloss value of the surface on the opposite side to the surface to which a workpiece or the like is attached is low, and there is room for improvement in laser marking properties.

Furthermore, in the sheet for forming a protective film for chips disclosed in Patent Document 2, it is necessary to increase the amount of the inorganic filler blended in the layer for forming a protective film of the sheet in order to improve the heat dissipation properties of the protective film to be formed. However, in a semiconductor chip having a protective film formed by curing a layer for forming a protective film in which an inorganic filler is blended in a large amount, when it is incorporated into a semiconductor device, lifting-off or peeling-off in the joint portion with the protective film occur or cracks occur due to temperature change by the repetition of heat generation and cooling, and a new problem of reduction in the reliability of the chip occurs.

Patent Document 3 discloses a film for flip chip type semiconductor back surface, which is to be disposed on the back surface of a semiconductor element to be flip chip-connected onto an adherent, wherein the average particle size of the filer is at most 30%, relative to the film for flip chip type semiconductor back surface. Therefore, the average particle size of the metal compound particle is below 0.3 times of the thickness of the film for forming a protective film and may be improved.

An object of the present invention is to provide a composite sheet for forming a protective film that can form a protective film with good heat dissipation properties and marking properties and can manufacture a highly reliable chip with protective film and a method for fabricating a chip with protective film.

### MEANS FOR SOLVING THE PROBLEM

The present inventors have found that a composite sheet according to claim 1 and a method of fabricating a chip with protective film according to claim 11 can solve the problem mentioned above, and have completed the present invention.

Advantageous embodiments of the invention are set out in the dependent claims.

### EFFECTS OF THE INVENTION

A composite sheet for forming a protective film of the present invention can form a protective film with good heat dissipation properties and marking properties and can manufacture a highly reliable chip with protective film.

### BRIEF DESCRIPTION OF THE DRAWINGS

[Fig. 1] Fig. 1 is cross-sectional views of composite sheets for forming a protective film showing the 1st to 3rd configuration of the composite sheet for forming a protective film of the present invention.
[Fig. 2] Fig. 2 is cross-sectional views of composite sheets for forming a protective film showing the 4th to 6th configuration of the composite sheet for forming a protective film of the present invention.

### MODE FOR CARRYING OUT THE INVENTION

In the following description in the present specification, the "mass average molecular weight (Mw)" is the value in polystyrene equivalent measured by the gel permeation chromatography (GPC) method, and is specifically the value measured on the basis of the method described in Examples.

Furthermore, for example, the "(meth)acrylate" is used as a term representing both "acrylate" and "methacrylate," and this applies also to other similar terms.

In the description in the present specification, the "energy ray" refers to, for example, ultraviolet light, an electron ray, or the like, and is preferably ultraviolet light.

In the present invention, the effective components in a composition refer to components excluding the solvent such as water and an organic solvent from the components contained in the composition.

[Composite sheet for forming a protective film]

A composite sheet for forming a protective film of the present invention is a composite sheet including a pressure sensitive adhesive sheet having a pressure sensitive adhesive layer on a substrate and a film for forming a protective film formed of a composition for forming a protective film on at least part of the pressure sensitive adhesive layer.

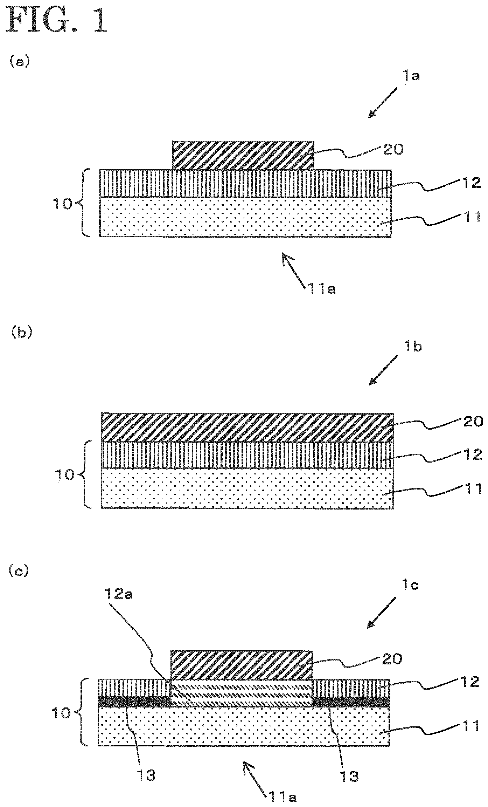

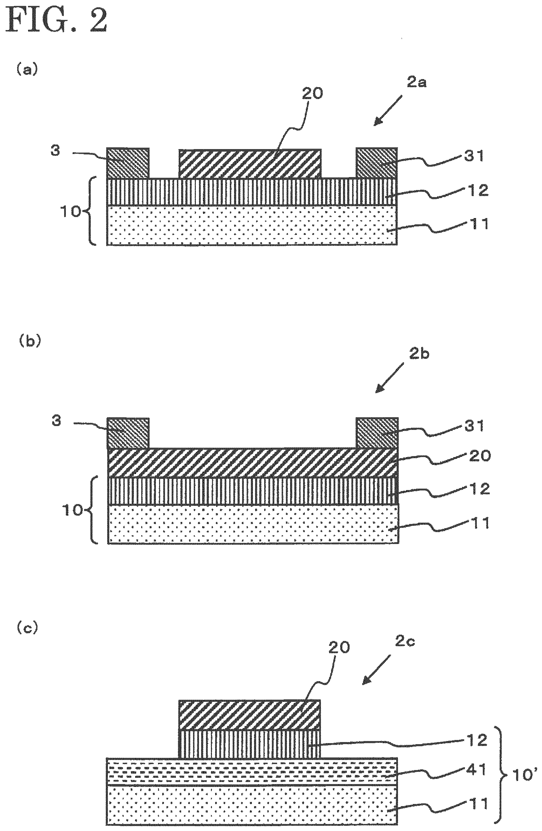

Fig. 1 and Fig. 2 are cross-sectional views of composite sheets for forming a protective film showing an example of the configuration of the composite sheet for forming a protective film of the present invention.

As shown in Fig. 1 and Fig. 2, the composite sheet for forming a protective film of the present invention preferably has a configuration in which a film for forming a protective film 20 is directly stacked on at least part of a pressure sensitive adhesive layer 12 from the viewpoint of improving the marking properties of a protective film to be formed.

As the 1st configuration of the composite sheet for forming a protective film of the present invention, as shown in Fig. 1(a), a composite sheet for forming a protective film 1a in which a pressure sensitive adhesive sheet 10 having the pressure sensitive adhesive layer 12 on a substrate 11 and the film for forming a protective film 20 is directly stacked on part of the pressure sensitive adhesive layer 12 is given.

As the 2nd configuration of the composite sheet for forming a protective film of the present invention, as shown in Fig. 1(b), a composite sheet for forming a protective film 1b in which the film for forming a protective film 20 is directly stacked on the entire surface of the pressure sensitive adhesive layer 12 is given. In the composite sheet for forming a protective film 1b, the film for forming a protective film 20 and the pressure sensitive adhesive sheet 10 are in the same shape.

The composite sheet for forming a protective film of the present invention may be one in which the film for forming a protective film 20 is adjusted to substantially the same shape as that of a workpiece such as a semiconductor wafer or a shape that can include the whole shape of a workpiece. The composite sheet for forming a protective film of the present invention may be one of a configuration like the composite sheet for forming a protective film 1a including the pressure sensitive adhesive sheet 10 larger than the film for forming a protective film 20.

As the 3rd configuration of the composite sheet for forming a protective film of the present invention, as shown in Fig. 1(c), a composite sheet for forming a protective film 1c having a configuration in which the pressure sensitive adhesive layer 12 is a layer formed of an energy ray curable pressure sensitive adhesive, at least part of the pressure sensitive adhesive layer 12 has a cured region 12a cured by irradiation with an energy ray beforehand, and the film for forming a protective film 20 is directly stacked on the cured region 12a is given.

In the composite sheet for forming a protective film 1c, it is preferable that regions of the pressure sensitive adhesive layer other than the cured region 12a not be irradiated with an energy ray and maintain high adhesive strength.

To perform energy ray irradiation on only the place in the pressure sensitive adhesive layer 12 where the cured region 12a will be formed, for example, it is possible to provide an energy ray shield layer 13 by printing or the like at the boundary between the substrate 11 and the pressure sensitive adhesive layer 12 other than the place where the cured region 12a will be formed and perform energy ray irradiation from the substrate side 11a.

As the 4th configuration of the composite sheet for forming a protective film of the present invention, as shown in Fig. 2(a), a composite sheet for forming a protective film 2a in which a jig adhesion layer 31 is provided on the surface of the pressure sensitive adhesive layer 12 on which the film for forming a protective film 20 is not stacked is given.

As shown in Fig. 2(b), as the 5th configuration of the composite sheet for forming a protective film of the present invention, a composite sheet for forming a protective film 2b in which the film for forming a protective film 20 and the pressure sensitive adhesive sheet 10 are in the same shape and the jig adhesion layer 31 is provided on an outer peripheral portion of the surface of the film for forming a protective film 20 is possible.

By providing the jig adhesion layer 31, when a jig such as a ring frame is attached to an outer peripheral portion of the surface of the film for forming a protective film 20, the adhesive strength to the jig can be made good.

The jig adhesion layer 31 may be formed of a double-sided pressure sensitive adhesive sheet having a substrate (a core material) or a layer made of a pressure sensitive adhesive.

As the substrate (the core material) used to form the jig adhesion layer 31, one the same as the substrate 11 of the pressure sensitive adhesive sheet 10 may be used. As the pressure sensitive adhesive used to form the jig adhesion layer 31, one the same as the pressure sensitive adhesive forming the pressure sensitive adhesive layer 12 of the pressure sensitive adhesive sheet 10 may be used.

The thickness of the jig adhesion layer 31 is preferably 1 to 80 $\mu$m, more preferably 5 to 60 $\mu$m, and still more preferably 10 to 40 $\mu$m.

As the 6th configuration of the composite sheet for forming a protective film, as shown in Fig. 2(c), a composite sheet for forming a protective film 2c having the film for forming a protective film 20 and a pressure sensitive adhesive sheet 10' is given. The pressure sensitive adhesive sheet 10' that the composite sheet for forming a protective film 2c has includes the pressure sensitive adhesive layer 12 in a shape that can include the shape of the film for forming a protective film 20, and has a configuration in which a pressure sensitive adhesive layer for jig adhesion 41 is provided separately from the pressure sensitive adhesive layer 12 between the substrate 11 and the pressure sensitive adhesive layer 12.

As the pressure sensitive adhesive layer for jig adhesion 41, one the same as or different from the pressure sensitive adhesive forming the pressure sensitive adhesive layer 12 may be used, but is preferably formed of a pressure sensitive adhesive with an adhesive strength higher than that of the pressure sensitive adhesive layer 12.

By providing the pressure sensitive adhesive layer for jig adhesion 41, when the region where the pressure sensitive adhesive layer 12 does not exist out of the region in a planar view of the pressure sensitive adhesive layer for jig adhesion 41 and a jig such as a ring frame are attached, the adhesiveness at the interface between the film for forming a protective film 20 and the pressure sensitive adhesive layer 12 can be controlled while the adhesiveness to the jig is enhanced. Consequently, when a chip is manufactured using the composite sheet for forming a protective film 2c, the workability of picking-up of chips with protective film can be improved.

The thickness of the pressure sensitive adhesive layer for jig adhesion 41 is preferably 1 to 50 $\mu$m, more preferably 3 to 40 $\mu$m, and still more preferably 3 to 30 $\mu$m.

In the composite sheet for forming a protective film of the present invention, a release sheet may be further provided on the film for forming a protective film 20, the exposed surface of the pressure sensitive adhesive layer 12 on which the film for forming a protective film 20 is not stacked, the jig adhesion layer 31, and the exposed surface of the pressure sensitive adhesive layer for jig adhesion 41 on which the pressure sensitive adhesive layer 12 is not stacked.

As the release sheet, one in which a release agent is applied onto at least one surface of a substrate for the release sheet and release treatment is performed is given.

As the substrate for the release sheet, one the same as a resin film forming the substrate described later is given.

As the release agent, for example, an alkyd-based release agent, a silicone-based release agent, a fluorine-based release agent, an unsaturated polyester-based release agent, a polyolefin-based release agent, a wax-based release agent, and the like are given. Of these, an alkyd-based release agent, a silicone-based release agent, and a fluorine-based release agent are preferable from the viewpoint of heat resistance.

The thickness of the release sheet is not particularly limited, but is preferably 10 to 500 $\mu$m, more preferably 15 to 300 $\mu$m, and still more preferably 20 to 200 $\mu$m.

Details of the substrate, the pressure sensitive adhesive layer, and the film for forming a protective film constituting the composite sheet for forming a protective film of the present invention will now be described.

[Substrate]

As the substrate of the pressure sensitive adhesive sheet used in the present invention, for example, a resin film such as a polyethylene film, a polypropylene film, a polybutene film, a polybutadiene film, a polymethylpentene film, a polyvinyl chloride film, a vinyl chloride copolymer film, a polyethylene terephthalate film, a polyethylene naphthalate film, a polybutylene terephthalate film, a polyurethane film, an ethylene-vinyl acetate copolymer film, an ionomer resin film, an ethylene-(meth)acrylic acid copolymer film, an ethylene-(meth)acrylic acid ester copolymer film, a polystyrene film, a polycarbonate film, a polyimide film, and a fluorine resin film is given.

These resin films may be cross-linked films.

The substrate may be a single-layer film formed of one type of resin film, or may be a multiple-layer film in which two or more types of resin films are stacked. Also a colored resin film may be used.

Of these substrates, a resin film with good heat resistance is preferable.

Even when the film for forming a protective film is a thermosetting one and the film for forming a protective film is thermally cured before peeled off from the pressure sensitive adhesive sheet, by using a resin film with good heat resistance as the substrate, damage to the substrate due to heat can be suppressed and the occurrence of defects in the fabricating process of a semiconductor device can be suppressed.

As the substrate used in the present invention, a substrate including a polypropylene film is more preferable from the viewpoints of being good in heat resistance, having expansion aptitude due to having moderate flexibility, and good picking-up aptitude being easily maintained when the composite sheet for forming a protective film is used for the fabricating of a chip with protective film.

The configuration of the substrate including a polypropylene film may be a single-layer structure formed of only a polypropylene film, or may be a multiple-layer structure formed of a polypropylene film and another resin film.

The thickness of the substrate is preferably 10 to 500 $\mu$m, more preferably 15 to 300 $\mu$m, and still more preferably 20 to 200 $\mu$m.

[Pressure sensitive adhesive layer]

As the pressure sensitive adhesive forming the pressure sensitive adhesive layer of the pressure sensitive adhesive sheet used in the present invention, one having high adhesive strength may be used, a weakly pressure sensitive adhesive one having such an adhesive strength that the film for forming a protective film can be peeled off may be used, or an energy ray curable one of which the adhesive strength is reduced by energy ray irradiation may be used.

As specific pressure sensitive adhesives forming the pressure sensitive adhesive layer, for example, an acrylic-based pressure sensitive adhesive, a rubber-based pressure sensitive adhesive, a silicone-based pressure sensitive adhesive, an urethane-based pressure sensitive adhesive, a vinyl ether-based pressure sensitive adhesive, an energy ray curable pressure sensitive adhesive, a pressure sensitive adhesive with surface unevenness, a pressure sensitive adhesive containing a thermally expandable component, and the like are given.

Of these, an acrylic-based pressure sensitive adhesive is preferable from the viewpoints of keeping the interlaminar adhesion between the pressure sensitive adhesive layer to be formed and the film for forming a protective film and effectively suppressing the pressure sensitive adhesive sheet being peeled off when the composite sheet for forming a protective film is used in a dicing process. Also an energy ray curable pressure sensitive adhesive is preferable from the viewpoint of it being possible for the pressure sensitive adhesive sheet to be peeled off easily when it is attempted to remove the pressure sensitive adhesive sheet.

In the case where the pressure sensitive adhesive layer is formed using an energy ray curable pressure sensitive adhesive, it is preferable that at least part of the pressure sensitive adhesive layer have a cured region cured by irradiation with an energy ray beforehand. By forming the pressure sensitive adhesive layer having such a cured region, when the film for forming a protective film is directly stacked on the cured region, the deformation of the film for forming a protective film is suppressed and smoothness can be kept in the process of curing of the film for forming a protective film (in particular, the process of curing by heat), and a protective film with a high gloss value can be formed.

The pressure sensitive adhesive may contain another additive such as a curable component, a cross-linker, a tackifying resin, a photopolymerization initiator, an antioxidant, a stabilizer, a softener, a filler, a pigment, and a dye.

As the curable component, one the same as a curable component (B) described later that can be contained in the composition for forming a protective film is given.

As the cross-linker, for example, an organic polyvalent isocyanate-based cross-linker, an organic multivalent imine-based cross-linker, and the like are given, and specifically one the same as a cross-linker (F) described later that can be contained in the composition for forming a protective film is given.

As the tackifying resin, for example, a rosin-based resin, a hydrogenated rosin-based resin, a terpene-based resin, a hydrogenated terpene-based resin, a C5-based petroleum resin obtained by copolymerizing C5 fractions, a hydrogenated petroleum resin of a C5-based petroleum resin, a C9-based petroleum resin obtained by copolymerizing C9 fractions, a hydrogenated petroleum resin of a C9-based petroleum resin, and the like are given.

The thickness of the pressure sensitive adhesive layer is preferably 1 to 100 $\mu$m, more preferably 3 to 50 $\mu$m, and still more preferably 5 to 25 $\mu$m.

<Method for fabricating the pressure sensitive adhesive sheet>

The method for fabricating the pressure sensitive adhesive sheet is not particularly limited, and the pressure sensitive adhesive sheet can be manufactured in a way that, for example, the other additive described above is blended in the pressure sensitive adhesive mentioned above as necessary, dilution is performed with an organic solvent to prepare a pressure sensitive adhesive solution, then the pressure sensitive adhesive solution is applied onto a substrate by a known method to form a coating film, and the coating film is dried to form a pressure sensitive adhesive layer.

It is also possible to apply the pressure sensitive adhesive solution onto the release sheet described above to form a pressure sensitive adhesive layer on the release sheet and stack a substrate on the pressure sensitive adhesive layer to form a release sheet-equipped pressure sensitive adhesive sheet. During the use of the pressure sensitive adhesive sheet, the release sheet is removed and the film for forming a protective film is stacked on the exposed pressure sensitive adhesive layer.

As the organic solvent mentioned above, for example, toluene, ethyl acetate, methyl ethyl ketone, and the like are given. The solid content concentration of the pressure sensitive adhesive solution is preferably 10 to 80 mass%, more preferably 25 to 70 mass%, and still more preferably 45 to 65 mass%.

As the method for applying the pressure sensitive adhesive solution, for example, the spin coating method, the spray coating method, the bar coating method, the knife coating method, the roll coating method, the blade coating method, the die coating method, the gravure coating method, and the like are given.

[Film for forming a protective film]

The film for forming a protective film used in the present invention is formed of a composition for forming a protective film containing an inorganic filler (C) containing boron nitride particles (C1). The film for forming a protective film has curability, and preferably has thermosetting properties.

In the case where the film for forming a protective film has thermosetting properties, there is a tendency that after thermal setting, the smoothness of the surface of a protective film formed by curing the film for forming a protective film is lost and the marking properties of the protective film are less good. However, in the case of the composite sheet for forming a protective film of the present invention, since a protective film with a high gloss value can be formed even after thermal setting, a chip with protective film with good marking properties can be manufactured.

The thickness of the film for forming a protective film is preferably 3 to 200 $\mu$m, more preferably 10 to 150 $\mu$m, still more preferably 20 to 100 $\mu$m, and yet still more preferably 25 to 70 $\mu$m.

The composition for forming a protective film contains an inorganic filler (C) containing boron nitride particles (C1), and preferably further contains one or more selected from a polymer component (A), a curable component (B), a coloring agent (D), and a coupling agent (E).

The composition for forming a protective film may contain a cross-linker (F) and a general-purpose additive (G) to the extent that the effect of the present invention is not impaired.

Each component contained in the composition for forming a protective film used in the present invention will now be described.

<Component (A): Polymer component>

The composition for forming a protective film used in the present invention preferably contains a polymer component (A) from the viewpoints of providing flexibility and film formability to the film for forming a protective film formed of the composition for forming a protective film and making sheet condition maintenance characteristics good.

The content of the component (A) relative to the total amount (100 mass%) of the effective components contained in the composition for forming a protective film is preferably 5 to 50 mass%, more preferably 8 to 40 mass%, still more preferably 10 to 30 mass%, and yet still more preferably 12 to 25 mass%.

As the polymer component (A), an acrylic-based polymer (AI) is preferable, and a non-acrylic-based polymer (A2) other than the component (AI), such as a polyester, a phenoxy resin, a polycarbonate, a polyether, a polyurethane, a polysiloxane, and a rubber-based polymer, may be used.

These polymer components may be used singly or in combinations of two or more.

<Component (AI) : Acrylic-based polymer>

The mass average molecular weight (Mw) of the acrylic-based polymer (AI) is preferably 20,000 to 3,000,000, more preferably 100,000 to 1,500,000, still more preferably 150,000 to 1,200,000, and yet still more preferably 250,000 to 800,000 from the viewpoint of providing flexibility and film formability to the film for forming a protective film formed of the composition for forming a protective film.

The glass transition temperature (Tg) of the acrylic-based polymer (AI) is preferably -10 to 50°C, more preferably -3 to 40°C, still more preferably 1 to 30°C, and yet still more preferably 3 to 20°C from the viewpoints of the adhesiveness of the protective film formed of the film for forming a protective film and improvement in the reliability of the chip with protective film manufactured using the composite sheet for forming a protective film.

In the present invention, the glass transition temperature (Tg) of the acrylic-based polymer (AI) is a value converted to the Celsius temperature (unit: °C) scale of the glass transition temperature ($Tg_K$) on the absolute temperature (unit: K) scale calculated by the following formula (1).

$$\frac{100}{Tg_K} = \frac{W_1}{Tg_1} + \frac{W_2}{Tg_2} + \frac{W_3}{Tg_3} + \frac{W_4}{Tg_4} + \cdots \qquad (1)$$

wherein $W_1$, $W_2$, $W_3$, $W_4$, ... each represent a mass fraction (mass%) of each monomer component constituting the acrylic-based copolymer, and $Tg_1$, $Tg_2$, $Tg_3$, $Tg_4$, ... each represent a glass transition temperature expressed by the absolute temperature (K) scale of a homopolymer of each monomer component of the acrylic-based copolymer (AI).

As the acrylic-based polymer (AI), a polymer containing an alkyl (meth)acrylate as a main component is given, and specifically an acrylic-based polymer containing a constituent unit (a1) derived from an alkyl (meth)acrylate having an alkyl group having 1 to 18 carbon atoms is preferable, and an acrylic-based copolymer containing a constituent unit (a2) derived from a functional group-containing monomer along with the constituent unit (a1) is more preferable.

The component (AI) may be used singly or in combinations of two or more.

In the case where the component (AI) is a copolymer, the form of the copolymer may be any of a block copolymer, a random copolymer, an alternating copolymer, and a graft copolymer.

From the viewpoint of improving the reliability of the chip with protective film manufactured using the composite sheet for forming a protective film of the present invention and the viewpoint of improving the adhesive strength of the protective film formed of the film for forming a protective film, the content of the constituent unit derived from one or more epoxy group-containing monomer selected from an epoxy group-containing (meth)acrylic acid ester and a non-acrylic-based epoxy group-containing monomer relative to the total constituent units constituting the acrylic-based polymer (AI) is preferably 0 to 20 mass%, more preferably 1 to 16 mass%, and still more preferably 3 to 12 mass%.

In the case where the content of the constituent unit derived from epoxy group-containing monomer is 20 mass% or less, when the curable component (B) is blended, a phenomenon in which it is difficult for a phase-separated structure to be formed can be suppressed. Consequently, when a chip with protective film is manufactured using the composite sheet for forming a protective film, bad effects such as the occurrence of lifting-off or peeling-off in the joint portion between the protective film and the chip, and the occurrence of cracks due to temperature change can be suppressed, and the reliability of the chip with protective film can be made good. Furthermore, the adhesive strength of the protective film formed of the film for forming a protective film can be improved.

By using the acrylic-based polymer (AI) containing the constituent unit derived from epoxy group-containing monomer, the gloss value of the protective film measured from the opposite side of the chip with protective film manufactured using the composite sheet for forming a protective film from the side where the chip is present can be increased more, and a chip with protective film with good marking properties can be manufactured.

As the epoxy group-containing (meth)acrylic acid ester, for example, glycidyl (meth)acrylate, β-methylglycidyl (meth)acrylate, (3,4-epoxycyclohexyl)methyl (meth)acrylate, 3-epoxycyclo-2-hydroxypropyl (meth)acrylate, and the like are given.

As the non-acrylic-based epoxy group-containing monomer, for example, glycidyl crotonate, allyl glycidyl ether, and the like are given.

Of these epoxy group-containing monomers, an epoxy group-containing (meth)acrylic acid ester is preferable and glycidyl (meth)acrylate is more preferable from the viewpoint of increasing the gloss value of the protective film formed of the film for forming a protective film more.

The epoxy group-containing monomer corresponds to the functionality-containing monomer described above, and the constituent unit derived from the epoxy group-containing monomer is included in the constituent unit (a2) mentioned above.

(Constituent unit (a1))

The number of carbon atoms of the alkyl group of the alkyl (meth)acrylate that forms the constituent unit (a1) is preferably 1 to 18 from the viewpoint of providing flexibility and film formability to the film for forming a protective film formed of the composition for forming a protective film, more preferably 1 to 8 from the viewpoint of it being possible to avoid a reduction in handling characteristics due to an increase in the crystallinity of the side chain of the acrylic-based polymer, and still more preferably 1 to 3 from the viewpoint of improving the reliability of the chip with protective film manufactured using the composite sheet for forming a protective film.

The smaller the number of carbon atoms of the alkyl (meth)acrylate is, the higher the glass transition temperature of the homopolymer thereof is; therefore, by setting the number of carbon atoms of the alkyl (meth)acrylate to 1 to 3, it becomes easy to adjust the glass transition temperature (Tg) of the acrylic-based polymer (AI) to the range described above.

As the alkyl (meth)acrylate, for example, methyl (meth)acrylate, ethyl (meth)acrylate, propyl (meth)acrylate, butyl (meth)acrylate, pentyl (meth)acrylate, 2-ethylhexyl (meth)acrylate, isooctyl (meth)acrylate, n-octyl (meth)acrylate, n-nonyl (meth)acrylate, isononyl (meth)acrylate, decyl (meth)acrylate, lauryl (meth)acrylate, stearyl (meth)acrylate, and the like are given.

These alkyl (meth)acrylates may be used singly or in combinations of two or more.

Of these, an alkyl (meth)acrylate having an alkyl group having 1 to 3 carbon atoms is preferable.

As the alkyl (meth)acrylate having an alkyl group having 1 to 3 carbon atoms, methyl (meth)acrylate is preferable and methyl acrylate is more preferable from the viewpoint of providing flexibility and film formability to the film for forming a protective film formed of the composition for forming a protective film and the viewpoint of improving the reliability of the chip with protective film manufactured using the composite sheet for forming a protective film.

The content of the constituent unit derived from alkyl (meth)acrylates having an alkyl group having 4 or more carbon atoms relative to the total structural units constituting the acrylic-based polymer (AI) is preferably 0 to 12 mass%, more preferably 0 to 10 mass%, still more preferably 0 to 7 mass%, and yet still more preferably 0 to 3 mass% from the viewpoint of improving the reliability of the chip with protective film manufactured using the composite sheet for forming a protective film.

The content of the constituent unit (a1) relative to the total structural units constituting the acrylic-based polymer (AI) is preferably 50 mass% or more, more preferably 60 to 99 mass%, still more preferably 65 to 95 mass%, and yet still more preferably 70 to 90 mass%.

The content of the constituent unit derived from alkyl (meth)acrylate having an alkyl group having 1 to 3 carbon atoms in the constituent unit (a1) is preferably 80 to 100 mass%, more preferably 90 to 100 mass%, still more preferably 97 to 100 mass%, and yet still more preferably 100 mass% from the viewpoint of improving the reliability of the chip with protective film manufactured using the composite sheet for forming a protective film.

(Constituent unit (a2))

As the monomer containing a functional group other than epoxy groups which forms the constituent unit (a2), for example, a carboxy group-containing monomer, a hydroxyl group-containing monomer, an amide group-containing monomer, an amino group-containing monomer, a cyano group-containing monomer, a keto group-containing monomer, a monomer having a nitrogen atom-containing ring, an alkoxysilyl group-containing monomer, and the like are given. Of these, a hydroxyl group-containing monomer is preferable.

These functional group-containing monomers may be used singly or in combinations of two or more.

As the hydroxyl group-containing monomer, for example, hydroxyalkyl (meth)acrylates such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, and 4-hydroxybutyl (meth)acrylate; unsaturated alcohols such as vinyl alcohol and allyl alcohol; and the like are given.

Of these, 2-hydroxyethyl (meth)acrylate is preferable and 2-hydroxyethyl acrylate is more preferable.

By using the carboxy group-containing monomer, a carboxy group is introduced into the acrylic-based polymer (A1): and when the film for forming a protective film contains an energy ray curable component as the curable component (B), the compatibility between the component (B) and the component (A) can be made good.

As the carboxyl group-containing monomer, (meth)acrylic acid, maleic acid, fumaric acid, itaconic acid, and the like are given.

In the case where an epoxy-based thermosetting component is used as the curable component (B) described later, the carboxyl group and the epoxy group in the epoxy-based thermosetting component react together; thus, the content of the structural units derived from carboxyl group-containing monomers is preferably small.

In the case where an epoxy-based thermosetting component is used as the curable component (B), the content of the structural unit derived from carboxyl group-containing monomer is preferably 0 to 10 mass%, more preferably 0 to 5 mass%, still more preferably 0 to 2 mass%, and yet still more preferably 0 mass% relative to the total constituent units constituting the acrylic-based polymer (Al).

The content of the constituent unit (a2) relative to the total structural units constituting the acrylic-based polymer (Al) is preferably 0 to 40 mass%, more preferably 5 to 30 mass%, still more preferably 8 to 25 mass%, and yet still more preferably 10 to 20 mass%.

(Constituent unit (a3))

The acrylic-based polymer (Al) used in the present invention may contain a constituent unit (a3) derived from another monomer other than the constituent units (a1) and (a2) mentioned above to the extent that the effect of the present invention is not impaired.

As the other monomer, for example, vinyl acetate, styrene, ethylene, an α-olefin, and the like are given.

The content of the constituent unit (a3) relative to the total structural units constituting the acrylic-based polymer (Al) is preferably 0 to 10 mass%, more preferably 0 to 5 mass%, still more preferably 0 to 2 mass%, and yet still more preferably 0 mass%.

<Component (A2) : non-acrylic-based resin>

The composition for forming a protective film used in the present invention may contain, as necessary, a non-acrylic-based resin (A2) as a resin component other than the acrylic-based polymer (Al) described above.

As the non-acrylic-based resin (A2), for example, a polyester, a phenoxy resin, a polycarbonate, a polyether, a polyurethane, a polysiloxane, a rubber-based polymer, and the like are given.

These resins may be used singly or in combinations of two or more.

The mass average molecular weight of the non-acrylic-based resin (A2) is preferably 20,000 or more, more preferably 20,000 to 100,000, and still more preferably 20,000 to 80,000.

The non-acrylic-based resin (A2) may be used singly; but by using it in combination with the acrylic-based polymer (Al) described above, after a protective film is formed on an adherend using the composite sheet for forming a protective film attached to the adherend, the pressure sensitive adhesive sheet can be peeled off easily and the occurrence of voids or the like can be suppressed.

In the case where the non-acrylic-based resin (A2) is used in combination with the acrylic-based polymer (Al) described above, the mass ratio between the non-acrylic-based resin (A2) and the acrylic-based polymer (Al) [(A2)/(A1)] is preferably 1/99 to 60/40 and more preferably 1/99 to 30/70 from the viewpoints mentioned above.

Although the acrylic-based polymer (Al) in the case where a constituent unit derived from an epoxy group-containing monomer is included in the constituent units constituting the acrylic-based polymer (AI) and a phenoxy resin having an epoxy group have thermosetting properties, these are regarded as being included in the concept of the polymer component (A), not in the concept of the curable component (B).

<Component (B): Curable component>

The composition for forming a protective film used in the present invention preferably contains a curable component (B) along with the polymer component (A) from the viewpoint of forming a hard protective film by curing the film for forming a protective film formed of the composition.

As the curable component (B), a thermosetting component (B1) or an energy ray curable component (B2) is preferably used, and these may be used in combination. As described above, since the action and effect of the composite sheet for forming a protective film of the present invention are exhibited favorably when the film for forming a protective film has thermosetting properties, the composition for forming a protective film preferably contains the thermosetting component (B1).

The thermosetting component (B1) contains at least a compound having a functional group that reacts by heating.

The energy ray curable component (B2) contains a compound (B21) having a functional group that reacts by energy ray irradiation, and is polymerized and cured upon irradiation with an energy ray of ultraviolet light or an electron ray.

Functional groups that these curable components have react together to form a three-dimensional network structure, and curing is thereby performed.

The mass average molecular weight (Mw) of the curable component (B) is preferably 10,000 or less and more preferably 100 to 10,000 from the viewpoint of using it in combination with the polymer component (A) to suppress the viscosity of the composition for forming a protective film for forming the film for forming a protective film and thereby improving handling characteristics or the like.

(Thermosetting component (B1))

As the thermosetting component (B1), an epoxy-based thermosetting component is preferable.

As the epoxy-based thermosetting component, one in which a compound (B11) having an epoxy group and a thermosetting agent (B12) are combined is preferably used.

As the compound (B11) having an epoxy group (hereinafter, occasionally referred to as an "epoxy compound (B11)"), for example, an epoxy compound having two or more functions in a molecule such as a polyfunctional epoxy resin, bisphenol A diglycidyl ether and a hydrogenated substance thereof, an orthocresol novolac epoxy resin, a dicyclopentadiene-type epoxy resin, a biphenyl-type epoxy resin, a bisphenol A-type epoxy resin, a bisphenol F-type epoxy resin, and a phenylene skeleton-type epoxy resin and the like are given.

These epoxy compounds (B11) may be used singly or in combinations of two or more.

The content of the epoxy compound (B11) is preferably 1 to 500 parts by mass, more preferably 3 to 300 parts by mass, still more preferably 10 to 150 parts by mass, and yet still more preferably 20 to 120 parts by mass relative to 100 parts by mass of the polymer component (A).

(Thermosetting agent (B12))

The thermosetting agent (B12) functions as a curing agent to the epoxy compound (B11).

As the thermosetting agent, a compound having two or more functional groups capable of reacting with an epoxy group in one molecule is preferable.

As the functional group, a phenol-type hydroxyl group, an alcohol-type hydroxyl group, an amino group, a carboxyl group, an acid anhydride, and the like are given. Of these, a phenol-type hydroxyl group, an amino group, or an acid anhydride is preferable, a phenol-type hydroxyl group or an amino group is more preferable, and an amino group is still more preferable.

As the phenol-based thermosetting agent having a phenol group, for example, a polyfunctional phenol resin, a biphenol, a novolac-type phenol resin, a dicyclopentadiene-based phenol resin, a xyloc-type phenol resin, an aralkyl phenol resin, and the like are given.

As the amine-based thermosetting agent having an amino group, for example, dicyandiamide (DICY) and the like are given.

These thermosetting agents (B12) may be used singly or in combinations of two or more.

The content of the thermosetting agent (B12) is preferably 0.1 to 500 parts by mass and more preferably 1 to 200 parts by mass relative to 100 parts by mass of the epoxy compound (B11).

(Curing accelerator (B13))

A curing accelerator (B13) may be used in order to adjust the rate of thermal setting of the film for forming a protective film. The curing accelerator (B13) is preferably used as the thermosetting component (B1) in combination with the epoxy compound (B11).

As the curing accelerator (B13), for example, tertiary amines such as triethylenediamine, benzyldimethylamine, triethanolamine, dimethylaminoethanol, and tris(dimethylaminomethyl)phenol; imidazoles such as 2-methylimidazole, 2-phenylimidazole, 2-phenyl-4-methylimidazole, 2-phenyl-4,5-dihydroxymethylimidazole, and 2-phenyl-4-methyl-5-hydroxymethylimidazole; organic phosphines such as tributylphosphine, diphenylphosphine, and triphenylphosphine; tetraphenylborates such as tetraphenylphosphonium tetraphenylborate and triphenylphosphine tetraphenylborate; and the like are given.

These curing accelerators (B13) may be used singly or in combinations of two or more.

The content of the curing accelerator (B13) is preferably 0.01 to 10 parts by mass, more preferably 0.1 to 6 parts by mass, and still more preferably 0.3 to 4 parts by mass relative to 100 parts by mass of the total amount of the epoxy compound (B11) and the thermosetting agent (B12) from the viewpoints of improvement in the adhesiveness of the protective film formed of the film for forming a protective film and improvement in the reliability of the chip with protective film manufactured using the composite sheet for forming a protective film.

(Energy ray curable component (B2))

As the energy ray curable component (B2), a compound (B21) having a functional group that reacts by energy ray irradiation may be used singly; but it is preferable to use a photopolymerization initiator (B22) in combination with the compound (B21).

The energy ray in the present invention refers to ultraviolet light, an electron ray, or the like, and is preferably ultraviolet light.

(Compound (B21) having a functional group that reacts by energy ray irradiation)

As the compound (B21) having a functional group that reacts by energy ray irradiation (hereinafter, occasionally referred to as an "energy ray reactive compound (B21)"), for example, trimethylolpropane triacrylate, pentaerythritol triacrylate, pentaerythritol tetraacrylate, dipentaerythritol monohydroxy pentaacrylate, dipentaerythritol hexaacrylate, 1,4-butylene glycol diacrylate, 1,6-hexanediol diacrylate, an oligoester acrylate, an urethane acrylate-based oligomer, an epoxy acrylate, a polyether acrylate, an itaconic acid oligomer, and the like are given.

These energy ray reactive compounds (B21) may be used singly or in combinations of two or more.

The mass average molecular weight (Mw) of the energy ray reactive compound (B21) is preferably 100 to 30,000 and more preferably 300 to 10,000.

The content of the energy ray reactive compound (B21) is preferably 1 to 1500 parts by mass and more preferably 3 to 1200 parts by mass relative to 100 parts by mass of the polymer component (A).

(Photopolymerization initiator (B22))

By using the energy ray reactive compound (B21) described above in combination with a photopolymerization initiator (B22), the polymerization curing time can be shortened, and the curing of the film for forming a protective film can be advanced even when the amount of ray irradiation is small.

As the photopolymerization initiator (B22), for example, benzophenone, acetophenone, benzoin, benzoin methyl ether, benzoin ethyl ether, benzoin isopropyl ether, benzoin isobutyl ether, benzoin benzoate, benzoin methyl benzoate, benzoin dimethyl ketal, 2,4-diethylthioxanthone, $\alpha$-hydroxycyclohexyl phenyl ketone, benzyl diphenyl sulfide, tetramethylthiuram monosulfide, azobisisobutyronitrile, benzyl, dibenzyl, diacetyl, 1,2-diphenylmethane, 2-hydroxy-2-methyl-1-[4-(1-methylvinyl)phenyl]propanone, 2,4,6-trimethylbenzoyldiphenylphosphine oxide, $\beta$-chloroanthraquinone, and the like are given.

These photopolymerization initiators (B22) may be used singly or in combinations of two or more.

The content of the photopolymerization initiator (B22) is preferably 0.1 to 10 parts by mass and more preferably 1 to 5 parts by mass relative to 100 parts by mass of the energy ray reactive compound (B21) from the viewpoints of advancing the curing reaction sufficiently and suppressing the production of residues.

The content of the component (B) relative to the total amount (100 mass%) of the effective components contained in the composition for forming a protective film of the present invention is preferably 5 to 50 mass%, more preferably 8 to 40 mass%, still more preferably 10 to 30 mass%, and yet still more preferably 12 to 25 mass%.

In the present invention, the content of the component (B) mentioned above is the total content of the thermosetting component (B1) containing the epoxy compound (B11), the thermosetting agent (B12), and the curing accelerator (B13) and the energy ray curable component (B2) containing the energy ray reactive compound (B21) and the photopolymerization initiator (B22) described above.

<Component (C): Inorganic filler>

The composition for forming a protective film of the present invention contains an inorganic filler (C) containing boron nitride particles (C1).

By the inorganic filler (C) being contained, the thermal conductivity of the protective film formed of the film for forming a protective film can be improved. Furthermore, by the boron nitride particle (C1) being contained as the component (C), the thermal conductivity of the protective film can be further improved and the generated heat of a semiconductor device mounted with a semiconductor chip with protective film can be diffused efficiently.

A protective film formed of a composition not containing the component (C1) has a tendency that, although the adhesive strength with an adherend such as copper foil and a resist is improved, the thermal conductivity is reduced and heat dissipation properties are less good.

According to the invention, the inorganic filler (C) further contains metal compound particles (C2) along with the component (C1) from the viewpoint of improvement in the thermal conductivity of the protective film formed of the film for forming a protective film and the viewpoint of improvement in the adhesiveness of the protective film.

By the metal compound particle (C2) being contained along with the component (C1) in the film for forming a protective film, the thermal conductivity in the thickness direction of the protective film is further improved and also the adhesiveness of the protective film is improved.

The content of the component (C) relative to the total amount (100 mass%) of the effective components contained in the composition for forming a protective film of the present invention is 10 to 70 mass%, preferably 20 to 67 mass%, more preferably 30 to 64 mass%, still more preferably 40 to 62 mass%, and yet still more preferably 45 to 60 mass%.

If the content of the component (C) is less than 10 mass%, the thermal conductivity of the protective film formed of the film for forming a protective film is reduced and the heat dissipation properties of the protective film are less good. On the other hand, if the content of the component (C) is more than 70 mass%, there is a tendency that a deformation due to temperature change occurs in the protective film of the chip with protective film manufactured using the composite sheet for forming a protective film and lifting-off or peeling-off in the joint portion between the protective film and the chip occur or cracks occur, and the reliability of the chip with protective film is reduced.

The content of the component (C) in the film for forming a protective film of the present invention is 10 to 50 volume%, more preferably 16 to 46 volume%, still more preferably 22 to 42 volume%, and yet still more preferably 26 to 39 volume% relative to the total volume (100 volume%) of the film for forming a protective film from the viewpoints of improvement in the thermal conductivity and the adhesiveness of the protective film formed of the film for forming a protective film and improvement in the reliability of the chip with protective film manufactured using the composite sheet for forming a protective film.

When the content of the component (C) is 10 volume% or more, the thermal conductivity of the protective film tends to be improved. On the other hand, when the content of the component (C) is 50 volume% or less, the adhesiveness of the protective film is good and the reliability of the chip with protective film is improved.

The value of the content (unit: volume%) of the component (C) in the film for forming a protective film mentioned above indicates the proportion of the calculated volume of the component (C) to the sum of the calculated volumes, which calculated volume is calculated from the specific gravity and the blend mass (effective component ratio) of the source material that forms the film for forming a protective film.

(Boron nitride particles (C1))

In the film for forming a protective film of the present invention, by boron nitride particles (C1) being contained as the inorganic filler (C), even by a small content, the thermal conductivity of the protective film formed by curing the film for forming a protective film can be improved and the heat dissipation properties of the protective film can be made good. Furthermore, the content of the component (C) relative to the total amount of the effective components contained in the composition for forming a protective film is prevented from being excessively large, and the reliability of the chip with protective film manufactured using the composite sheet for forming a protective film can be improved.

The shape of the boron nitride particle (C1) is preferably a particle having anisotropy, and its specific shape preferably has at least one shape selected from the group consisting of a plate-like shape, an acicular shape, and a scale-like shape.

In the present invention, the "anisotropic shape" refers to a shape in which the aspect ratio of the particle [(major axis number average diameter)/(minor axis number average diameter)] is 2 or more.

The aspect ratio of the boron nitride particle (C1) [(major axis number average diameter)/(minor axis number average diameter)] is preferably 2 or more, more preferably 2 to 30, still more preferably 5 to 25, yet still more preferably 8 to 20, and yet still more preferably 10 to 15 from the viewpoint of improving the thermal conductivity of the protective film formed of the film for forming a protective film.

In the present invention, the values of the major axis number average diameter and the minor axis number average diameter used to calculate the aspect ratio of the component (C) (containing the components (C1) and (C2)) is the number average particle size calculated as the arithmetic mean value obtained by measuring the major axis diameters and the minor axis diameters of 20 particles selected at random in a transmission electron microscope photograph and finding each arithmetic mean value.

The average particle size of the boron nitride particle (C1) is preferably 3 to 30 $\mu$m, more preferably 5 to 25 $\mu$m, still more preferably 8 to 20 $\mu$m, and yet still more preferably 10 to 16 $\mu$m.

In the present invention, the value of the average particle size of the component (C) (containing the components (C1) and (C2)) is the number average particle size calculated as the arithmetic mean value obtained by measuring the major axis diameters of 20 particles selected at random in a transmission electron microscope photograph and finding the arithmetic mean value thereof.

The particle size distribution (CV value) of boron nitride particles (C1) is preferably 5 to 40% and more preferably 10 to 30% from the viewpoint of providing an efficient and uniform thermal conductivity to the protective film formed of the film for forming a protective film.

In the present invention, the value of the particle size distribution (CV value) of the component (C) (containing the components (C1) and (C2)) is the value found by performing electron microscope observation, measuring the major axis diameters of 200 particles, finding the standard deviation of the major axis diameter, and calculating (standard deviation of major axis diameter)/(average particle size) using the value of the average particle size described above.

The thermal conductivity in the major axis direction of the boron nitride particle (C1) is preferably 60 to 400 W/(m·K) and more preferably 100 to 300 W/(m·K).

The density of the boron nitride particle (C1) is preferably 1.5 to 5.0 g/cm$^3$, more preferably 2.0 to 4.0 g/cm$^3$, and still more preferably 2.2 to 3.0 g/cm$^3$.

The content of the component (C1) relative to the total amount (100 mass%) of the composition for forming a protective film of the present invention is preferably 10 to 40 mass%, more preferably 12 to 30 mass%, still more preferably 14 to 26 mass%, and yet still more preferably 16 to 22 mass%.

When the content of the component (C1) relative to the total amount of the composition for forming a protective film is 10 mass% or more, the thermal conductivity of the protective film formed of the film for forming a protective film can be improved, and the protective film with good heat dissipation properties can be obtained. On the other hand, when the content of the component (C1) relative to the total amount of the composition for forming a protective film is 40 mass% or less, the adhesiveness of the protective film formed of the film for forming a protective film can be made good.

The content of the component (C1) relative to the total amount (100 mass%) of the component (C) is preferably 10 to 80 mass%, more preferably 13 to 65 mass%, still more preferably 15 to 50 mass%, and yet still more preferably 20 to 39 mass%.

When the content of the component (C1) relative to the total amount of the component (C) is 10 mass% or more, the thermal conductivity of the protective film formed of the film for forming a protective film can be improved, and the protective film with good heat dissipation properties can be obtained. On the other hand, when the content of the component (C1) relative to the total amount of the component (C) is 80 mass% or less, the adhesiveness of the protective film formed of the film for forming a protective film can be made good.

(Metal compound particles (C2))

As the metal compound particle (C2), for example, an alumina particle, a zinc oxide particle, a magnesium oxide particle, a titanium particle, and the like are given. Of these, a metal oxide particle such as an alumina particle, a zinc oxide particle, and a magnesium oxide particle is preferable and an alumina particle is more preferable from the viewpoint of improvement in the thermal conductivity of the protective film formed of the film for forming a protective film and the viewpoint of improvement in the adhesiveness of the protective film.

As the shape of the metal compound particle (C2), a spherical metal compound particle is preferable from the viewpoint of improvement in the thermal conductivity of the protective film formed of the film for forming a protective film and the viewpoint of improvement in the adhesiveness of the protective film.

Here, the aspect ratio of the metal compound particle (C2) [(major axis number average diameter)/(minor axis number average diameter)] is preferably 1.0 to 1.3, more preferably 1.0 to 1.2, still more preferably 1.0 to 1.1, and yet still more preferably 1.0 to 1.1 from the viewpoints mentioned above.

According to the invention, the average particle size of the metal compound particle (C2) is 0.35 to 0.85 times, still more preferably 0.40 to 0.75 times, and yet still more preferably 0.45 to 0.65 times of the thickness of the film for forming a protective film.

When it is 0.3 times or more, the thermal conductivity of the protective film formed of the film for forming a protective film can be improved. On the other hand, when it is 0.95 times or less, the smoothness of the protective film can be made good.

Specific average particle sizes of the metal compound particle (C2) are preferably 10 to 40 $\mu$m, more preferably 12 to 35 $\mu$m, still more preferably 15 to 30 $\mu$m, and yet still more preferably 17 to 25 $\mu$m from the viewpoints mentioned above.

The particle size distribution (CV value) of metal compound particles (C2) is preferably 5 to 40% and more preferably 10 to 30% from the viewpoints of improving the thermal conductivity of the protective film formed of the film for forming a protective film and improving the adhesiveness of the protective film.

The mass ratio between the component (C2) and the component (C1) [(C2)/(C1)] is preferably 1/2 to 7/1, more preferably 1/1 to 6/1, still more preferably 1.2/1 to 5/1, yet still more preferably 1.5/1 to 4/1, and yet still more preferably 1.7/1 to 3/1.

When the mass ratio is 1/2 or more, the thermal conductivity of the protective film formed of the film for forming a protective film can be improved and the adhesiveness of the protective film can be improved. On the other hand, when the mass ratio is 7/1, the increase of the viscosity of the composition for forming a protective film obtained can be suppressed and a smooth protective film can be formed.

The content of the component (C2) relative to the total amount (100 mass%) of the effective components contained in the composition for forming a protective film is preferably 20 to 60 mass%, more preferably 25 to 55 mass%, still more preferably 30 to 52 mass%, and yet still more preferably 33 to 50 mass%.

(Inorganic filler other than the components (C1) and (C2))

The composition for forming a protective film may contain, as the component (C), another inorganic filler other than the components (C1) and (C2).

As the another inorganic filler, for example, silica particles, silicon carbide particles, single-crystal fibers, glass fibers, and the like are given. Of these, silica particles are preferable.

The total content of the components (C1) and (C2) relative to the total amount (100 mass%) of the component (C) in the composition for forming a protective film is preferably 70 to 100 mass%, more preferably 80 to 100 mass%, still more preferably 90 to 100 mass%, and yet still more preferably 95 to 100 mass%.

<Component (D): Coloring agent>

The composition for forming a protective film preferably further contains a coloring agent (D).

By the coloring agent (D) being contained, when a semiconductor chip having the protective film formed of the film for forming a protective film is incorporated into a device, infrared light etc. generated from the surrounding devices can be blocked and the malfunction of the semiconductor chip can be prevented.

As the coloring agent (D), an organic or inorganic pigment and dye may be used.

As the dye, for example, any of an acid dye, a reactive dye, a direct dye, a disperse dye, a cationic dye, and the like may be used.

The pigment is not particularly limited, and known pigments appropriately selected may be used.

Of these, a black pigment is preferable from the viewpoints of the property of blocking electromagnetic waves and infrared light being good and improving distinguishability by the laser marking method more.

As the black pigment, for example, carbon black, iron oxide, manganese dioxide, aniline black, activated carbon, and the like are given, and carbon black is preferable from the viewpoint of enhancing the reliability of the semiconductor chip.

These coloring agents (D) may be used singly or in combinations of two or more.

The average particle size of the coloring agent (D) is preferably 1 to 200 nm, more preferably 5 to 100 nm, and still more preferably 10 to 50 nm.

The content of the component (D) relative to the total amount (100 mass%) of the effective components contained in the composition for forming a protective film is preferably 0.1 to 30 mass%, more preferably 0.5 to 25 mass%, still more preferably 1.0 to 15 mass%, and yet still more preferably 1.2 to 5 mass%.

<Component (E): Coupling agent>

The composition for forming a protective film preferably further contains a coupling agent (E).

By the coupling agent (E) being contained, the polymer component in the protective film formed of the film for forming a protective film and the surface of a semiconductor chip or the surface of a filler which is an adherend can be bonded, and adhesiveness and cohesiveness can be improved. Furthermore, water resistance can be improved without

14

impairing the heat resistance of the protective film.

As the coupling agent (E), a compound that reacts with a functional group that the component (A) or the component (B) has is preferable, and a silane coupling agent is more preferable.

As the silane coupling agent, for example, γ-glycidoxypropyltrimethoxysilane, γ-glycidoxypropylmethyldiethoxysilane, β-(3,4-epoxycyclohexyl)ethyltrimethoxysilane, γ-(methacryloxypropyl)trimethoxysilane, γ-aminopropyltrimethoxysilane, N-6-(aminoethyl)-γ-aminopropyltrimethoxysilane, N-6-(aminoethyl)-γ-aminopropylmethyldiethoxysilane, N-phenyl-γ-aminopropyltrimethoxysilane, γ-ureidopropyltriethoxysilane, γ-mercaptopropyltrimethoxysilane, γ-mercaptopropylmethyldimethoxysilane, bis(3-triethoxysilylpropyl)tetrasulfane, methyltrimethoxysilane, methyltriethoxysilane, vinyltrimethoxysilane, vinyltriacetoxysilane, imidazole silane, and the like are given.

The coupling agent (E) may be used singly or in combinations of two or more.

As the coupling agent (E), an oligomer-type coupling agent is preferable.

The molecular weight of the coupling agent (E) including oligomer-type coupling agents is preferably 100 to 15,000, more preferably 150 to 10,000, still more preferably 200 to 5,000, yet still more preferably 250 to 3,000, and yet still more preferably 350 to 2,000.

The content of the component (E) relative to the total amount (100 mass%) of the effective components contained in the composition for forming a protective film of the present invention is preferably 0.1 to 20 mass%, more preferably 0.15 to 10 mass%, still more preferably 0.2 to 5 mass%, and yet still more preferably 0.25 to 2 mass%.

<Component (F) : Cross-linker>

The composition for forming a protective film used in the present invention may further contain a cross-linker (F) in the case of containing, as the component (A), an acrylic-based copolymer containing the structural unit (a2) derived from a functional group-containing monomer described above.

By the cross-linker being contained, a network structure can be formed by a cross-linking reaction with the functional group of the acrylic-based copolymer mentioned above, and thereby the cohesive strength and the adhesive strength of the film for forming a protective film obtained can be improved.

As the cross-linker (F), for example, an organic polyvalent isocyanate compound, an organic polyvalent imine compound, and the like are given.

As the organic polyvalent isocyanate compound, for example, an aromatic polyvalent isocyanate compound, an aliphatic polyvalent isocyanate compound, an alicyclic polyvalent isocyanate compound, a trimer of these organic polyvalent isocyanate compounds, an isocyanate-terminated urethane prepolymer obtained by reacting these organic polyvalent isocyanate compounds and a polyol compound, and the like are given.

As the organic polyvalent isocyanate compound, for example, 2,4-tolylene diisocyanate, 2,6-tolylene diisocyanate, 1,3-xylene diisocyanate, 1,4-xylene diisocyanate, diphenylmethane-4,4'-diisocyanate, diphenylmethane-2,4'-diisocyanate, 3-methyldiphenylmethane diisocyanate, hexamethylene diisocyanate, isophorone diisocyanate, dicyclohexylmethane-4,4'-diisocyanate, dicyclohexylmethane-2,4'-diisocyanate, lysine isocyanate, a polyhydric alcohol adduct of these, and the like are given.

As the organic polyvalent imine compound, for example, N,N'-diphenylmethane-4,4'-bis(1-aziridinecarboxamide), trimethylolpropane-tri-β-aziridinylpropionate, tetramethylolmethane-tri-β-aziridinylpropionate, N,N'-toluene-2,4-bis(1-aziridinecarboxamide), triethylenemelamine, and the like are given.

The content of the cross-linker (F) is preferably 0.01 to 20 parts by mass, more preferably 0.1 to 10 parts by mass, and still more preferably 0.5 to 5 parts by mass relative to 100 parts by mass of the polymer component (A).

In the present invention, in the case where the content of the polymer component (A) is set as a standard for aspects of the content of the components forming the film for forming a protective film, when the polymer component (A) is a cross-linked acrylic-based polymer, the content as the standard is the content of the acrylic-based polymer before it is cross-linked.

<Component (G) : General-purpose additive>

The composition for forming a protective film of the present invention may contain a general-purpose additive (G) such as a release agent, a leveling agent, a plasticizer, an antistatic agent, an antioxidant, an ion scavenger, a gettering agent, and a chain transfer agent as necessary to the extent that the effect of the present invention is not impaired.

The content of each of these general-purpose additives (G) is appropriately adjusted as necessary to the extent that the effect of the present invention is not impaired, and is preferably 10 mass% or less, more preferably 5 mass% or less, and still more preferably 3 mass% or less relative to the total amount (100 mass%) of the effective components contained in the composition for forming a protective film of the present invention.

<Method for fabricating the film for forming a protective film>

There are no particular limitations on the method for fabricating the sheet for forming a protective film of the present invention, and the sheet can be manufactured by a known method. For example, an organic solvent is added to the composition for forming a protective film described above to obtain a form of a solution of the composition for forming a protective film, the solution is applied onto the release sheet described above by a known coating method to form a coating film, and then drying is performed to form a protective film; thus, the manufacturing can be performed.

As the organic solvent used, toluene, ethyl acetate, methyl ethyl ketone, and the like are given.

The solid content concentration of the solution of the composition for forming a protective film when an organic solvent is blended is preferably 10 to 80 mass%, more preferably 20 to 70 mass%, and still more preferably 30 to 65 mass%.

As the coating method, for example, the spin coating method, the spray coating method, the bar coating method, the knife coating method, the roll coating method, the roll knife coating method, the blade coating method, the die coating method, the gravure coating method, and the like are given.

[Properties and uses of the composite sheet for forming a protective film]

The composite sheet for forming a protective film of the present invention can be manufactured by attaching the pressure sensitive adhesive layer of the pressure sensitive adhesive sheet described above and the film for forming a protective film.

The thermal conductivity of the protective film formed by curing the film for forming a protective film of the composite sheet for forming a protective film of the present invention is preferably 1.5 W/(m·K) or more, more preferably 1.7 W/(m·K) or more, still more preferably 2.0 W/(m·K) or more, yet still more preferably 2.2 W/(m·K) or more, and yet still more preferably 2.5 W/(m·K) or more.

The thermal conductivity of the protective film refers to the value measured by the method described in Examples.

The film for forming a protective film of the composite sheet for forming a protective film of the present invention can form a protective film on an adherend. The film for forming a protective film is attached to a back surface of a workpiece such as a semiconductor wafer for chips of the face-down system and a semiconductor chip and is cured by an appropriate method; and has a function of protecting the back surface of the workpiece such as a semiconductor wafer and a semiconductor chip as a substitute for a sealing resin. For example, when attached to a semiconductor wafer, the protective film has a function of reinforcing the wafer and can therefore prevent the breakage etc. of the wafer.

Furthermore, the composite sheet for forming a protective film of the present invention can be used as a sheet for fixing a workpiece such as a semiconductor wafer during performing blade dicing, and makes it unnecessary to attach a dicing sheet separately to perform dicing; thus, the fabricating process of the semiconductor device can be simplified.

In addition, the composite sheet for forming a protective film of the present invention can be used also in what is called the dicing-before-grinding method (a method in which a trench deeper than the thickness of a chip to be obtained is formed in a semiconductor wafer from the circuit surface side and thinning processing is performed from the back surface side of the semiconductor wafer up to reaching at least the trench, and thereby a group of chips are obtained), and may be used by being attached to a group of chips fragmented.

[Chip with protective film]

A chip with protective film of the present invention has a protective film formed by attaching the composite sheet for forming a protective film of the present invention to the back surface of a workpiece such as a semiconductor wafer for chips and a semiconductor chip and curing the film for forming a protective film of the composite sheet for forming a protective film.

The protective film that the chip with protective film of the present invention has may be a completely cured one or may be a partially cured one, but is preferably a completely cured one.

For the protective film that the chip with protective film of the present invention has, the gloss value of the protective film measured from the opposite side of the chip with protective film from the side where the chip is present is preferably 25 or more and more preferably 30 or more. When the gloss value is 25 or more, a chip with protective film with good marking properties can be obtained.

The gloss value of the protective film of the chip with protective film may be measured using a workpiece with protective film before dicing in which a protective film is formed by performing curing treatment, as in Examples described later.

It is presumed that the gloss value of the protective film measured from the opposite side of the chip with protective film from the side where the chip is present and the gloss value of the protective film measured from the opposite side of the workpiece with protective film from the side where the workpiece is present are almost the same.

Because of having a protective film with a high thermal conductivity and a high gloss value, the chip with protective film of the present invention is good in heat dissipation properties and good in marking properties and can suppress the occurrence of lifting-off or peeling-off in the joint portion between the chip and the protective film and cracks due to temperature change, and is therefore good in reliability.

A semiconductor device can be manufactured by mounting the chip with protective film on a substrate or the like by the face-down system. A semiconductor device can be manufactured also by attaching the chip with protective film onto a die pad unit or another member such as another semiconductor chip (onto a chip mounting portion).

[Method for fabricating the chip with protective film]

There are no particular limitations on the method for fabricating the chip with protective film of the present invention, but a method based on blade dicing including the following steps (1) to (4), for example, is preferable:

step (1): a step of attaching the film for forming a protective film of the composite sheet for forming a protective film of the present invention to a back surface of a workpiece to obtain a workpiece equipped with the film for forming a protective film;
step (2): a step of dicing the workpiece equipped with the film for forming a protective film;
step (3): a step of curing the film for forming a protective film; and
step (4): a step of picking up the diced workpiece with protective film obtained through steps (1) to (3) to obtain a chip with protective film.

In the method for fabricating the chip with protective film of the present invention, the order of steps (2) and (3) is not limited, and the chip with protective film may be fabricated in the order of steps (1), (2), (3), and (4) or in the order of steps (1), (3), (2), and (4).

<Step (1)>

Step (1) is a step of attaching the film for forming a protective film of the composite sheet for forming a protective film of the present invention to a back surface of a workpiece such as a semiconductor wafer to obtain a workpiece equipped with the film for forming a protective film.

Here, the semiconductor wafer may be a silicon wafer, or may be a compound semiconductor wafer of gallium, arsenide or the like. The semiconductor wafer may be one in which a circuit is formed on its surface and its back surface is appropriately processed by grinding or the like to make the thickness approximately 50 to 500 $\mu$m.

<Step (2)>

Step (2) is a step of dicing the workpiece equipped with the film for forming a protective film or a workpiece with protective film into chips, which dicing is performed for each circuit formed on the workpiece surface.

The object to be diced in this step may be the workpiece equipped with the film for forming a protective film obtained through step (1), or may be the workpiece with protective film obtained through experiencing step (3) first after step (1).

The dicing of the workpiece may be performed by a known method.

Here, in the case of having experienced this step after step (1), a diced workpiece equipped with the film for forming a protective film is obtained; and in the next step (3), the film for forming a protective film is cured to obtain a diced workpiece with protective film.

On the other hand, in the case of having experienced step (3) after step (1), in this step the workpiece with protective film obtained in step (3) is diced to obtain a diced workpiece with protective film.

<Step (3)>

Step (3) is a step of curing the film for forming a protective film to form a protective film.

The film for forming a protective film can be cured by irradiation with heat and/or an energy ray.

As the conditions in the case where curing is performed by heating, the curing temperature is preferably 100 to 150°C and the curing time is preferably 1 to 3 hours.

The conditions in the case where curing is performed by irradiation with an energy ray are set as appropriate in accordance with the type of the energy ray used. For example, in the case of using ultraviolet light, the illuminance is preferably 170 to 250 mw/cm$^2$ and the quantity of light is preferably 600 to 1000 mJ/cm$^2$.

<Step (4)>

Step (4) is a step of picking up the diced workpiece with protective film obtained through steps (1) to (3) with a general-purpose means such as a collet to obtain a chip with protective film.

Through this step, a fragmented semiconductor chip having a protective film on its back surface (a chip with protective film) is obtained.

EXAMPLES

In the following description, the mass average molecular weight (Mw) and the number average molecular weight (Mn) of each component are the values measured by the method described below.

<Mass average molecular weight (Mw) and number average molecular weight (Mn)>

Measurement was performed under the following conditions using a gel permeation chromatography apparatus (product name: "HLC-8220 GPC", manufactured by Tosoh Corporation), and the value measured in standard polystyrene equivalent was used.

(Measurement conditions)

• Column: "TSK guard column HXL-H", "TSK gel GMHXL (×2)", "TSK gel G2000 HXL" (all of them are manufactured by Tosoh Corporation)
• Column temperature: 40°C
• Eluent: tetrahydrofuran
• Flow rate: 1.0 mL/min

Manufacturing Example 1

(Fabrication of a pressure sensitive adhesive sheet (1))

An acrylic-based copolymer (1) in which 80 mol% of 2-isocyanatoethyl methacrylate was added to 100 mol% of hydroxyl groups possessed by the side chains of a polymer having constituent units derived from 2-ethylhexyl acrylate (2EHA), vinyl acetate (VAc), and 2-hydroxyethyl acrylate (HEA) (2EHA/VAc/HEA = 40/40/20 (mass%), Mw = 600 thousand) was used.

5.3 parts by mass (effective component ratio) of a liquid bisphenol A-type epoxy resin (trade name: "jER828", manufactured by Mitsubishi Plastics, Inc.), 3.0 parts by mass (effective component ratio) of a photopolymerization initiator (trade name: "Irgacure 184", manufactured by BASF SE), and 0.5 parts by mass (effective component ratio) of a tolylene diisocyanate-based cross-linker (trade name: "BHS 8515", manufactured by Toyochem Co., Ltd.) were blended relative to 100 parts by mass of the acrylic-based copolymer (1), and methyl ethyl ketone was added as an organic solvent to prepare a pressure sensitive adhesive solution (1) with a solid content concentration of 30 mass%.

Then, the pressure sensitive adhesive solution (1) mentioned above was applied onto the release treatment surface of a release sheet release-treated with silicone (trade name: "SP-PET 381031", manufactured by LINTEC Corporation, thickness: 38 $\mu$m) using a roll-type coating apparatus so that the thickness after drying is 10 $\mu$m; thus, a coating film was formed.

Subsequently, drying processing was performed on the formed coating film at 110°C for 2 minutes to form an uncured pressure sensitive adhesive layer, then a polypropylene film with a thickness of 80 $\mu$m was attached as a substrate to the exposed surface of the pressure sensitive adhesive layer, and ultraviolet light irradiation (illuminance: 220 mW/cm$^2$, the quantity of light: 200 mJ/cm$^2$) was performed from the release sheet side to cure the uncured pressure sensitive adhesive layer; thus, a pressure sensitive adhesive sheet (1) was fabricated.

Examples 1 to 5 and Comparative Examples 1 to 4

(1) Preparation of a composition for forming a protective film

The components (A) to (E) of the kind and blend amount shown in Table 2 were blended to prepare a composition for forming a protective film, and then a methyl ethyl ketone solution was added so that the effective components concentration is 61 mass%; thus, a solution of the composition for forming a protective film was obtained.

The blend amount of each component shown in Table 2 is the mass ratio (effective component ratio) when the total amount of the composition for forming a protective film is assumed to be 100 parts by mass (effective components).

The details of the components (A) to (E) shown in Table 2 are as follows:

<Component (A): Polymer component>

The acrylic-based polymers of (A-1) to (A-4) shown in Table 1 below were used. The glass transition temperature (Tg) of the component (A) in Table 1 is the value converted to the Celsius temperature (unit: °C) scale of the glass transition temperature ($Tg_K$) on the absolute temperature (unit: K) scale calculated by Formula (1) above.

Table 1

| | Polymer component (A) | | | | |
| --- | --- | --- | --- | --- | --- |
| | Monomer component*1 (mass%) | | | Mw | Tg (°C) |
| | MA | HEA | GMA | | |
| A-1 | 85 | 15 | 0 | 400,000 | 4 |
| A-2 | 85 | 5 | 10 | 400,000 | 11 |
| A-3 | 85 | 10 | 5 | 400,000 | 9 |
| A-4 | 85 | 0 | 15 | 400,000 | 14 |
| *1: The abbreviations of the monomer components are as follows:<br>MA = methyl acrylate<br>HEA = 2-hydroxyethyl acrylate<br>GMA = glycidyl methacrylate | | | | | |

<Component (B): Curable component>

(Thermosetting component (epoxy compound))

An epoxy resin mixture in which the following epoxy resins (b1) to (b3) were mixed at (b1)/(b2)/(b3) = 60/10/30 (mass ratio) was used.

- (b1): trade name: "BPA 328", manufactured by Nippon Shokubai Co., Ltd., a liquid bisphenol A-type epoxy resin.
- (b2): trade name: "Epikote 1055", manufactured by Mitsubishi Chemical Corporation, a solid bisphenol A-type epoxy resin.
- (b3): trade name: "HP 7200 HH", manufactured by DIC Corporation, a dicyclopentadiene-type epoxy resin.

(Thermosetting agent)

- Trade name: "DICY", manufactured by Mitsubishi Chemical Corporation, dicyandiamide.

(Curing accelerator)

- Trade name: "2PH-Z", manufactured by Shikoku Chemicals Corporation, 2-phenyl-4, 5 - dihydroxymethylimidazole.

<Component (C1): Boron nitride particles>

- Trade name: "UHP-2", manufactured by Showa Denko K. K., plate-like boron nitride particles, average particle size: 11.8 μm, aspect ratio: 11.2, thermal conductivity in the major axis direction: 200 W/(m·K), density: 2.3 g/cm$^3$.

<Component (C2): Metal compound particles>

• Trade name: "CB-20A", manufactured by Showa Denko K. K., spherical alumina particles, aspect ratio: 1.0, average particle size: 20 μm.

<Component (D): Coloring agent>

• Trade name: "MA-600B", manufactured by Mitsubishi Chemical Corporation, carbon black, average particle size: 20 nm.

<Component (E): Silane coupling agent>

• Trade name: "X-41-1056", manufactured by Shin-Etsu Co., Ltd., an oligomer-type silane coupling agent, methoxy equivalent: 17.1 mmol/g, molecular weight: 500 to 1500.

(2) Fabrication of a film for forming a protective film

The solution of the composition for forming a protective film mentioned above was applied onto the release treatment surface of a release sheet release-treated with silicone (trade name: "SP-PET 381031", manufactured by LINTEC Corporation, thickness: 38 μm) using a roll-type coating apparatus so that the thickness after drying is 40 μm; thus, a coating film was formed.
Subsequently, drying processing was performed on the formed coating film at 110°C for 2 minutes to form a protective film with a thickness of 40 μm, and then a release sheet of the same type as the above separately prepared was attached to the exposed surface of the protective film; thus, a film for forming a protective film was fabricated.

(3) Fabrication of a composite film for forming a protective film

In Examples 1 to 5, the pressure sensitive adhesive sheet (1) fabricated in Manufacturing Example 1 and the release sheet of the film for forming a protective film mentioned above were each peeled off, and the pressure sensitive adhesive layer of the pressure sensitive adhesive sheet and the film for forming a protective film were attached together; thus, a composite film for forming a protective film was fabricated.
In Comparative Examples 1 to 3, the attachment of the pressure sensitive adhesive sheet and the film for forming a protective film was not performed, and the film for forming a protective film remains as it is.
Hereinafter, the composite sheet for forming a protective film of Examples 1 to 5 and Comparative Example 4 and the film for forming a protective film of Comparative Examples 1 to 3 are collectively referred to as a "(composite) sheet for forming a protective film."

(4) Fabricating of a semiconductor chip with protective film

The release sheet of the (composite) film for forming a protective film fabricated in the above manner was peeled off, and the (composite) film for forming a protective film was attached onto the ground surface of a silicon wafer ground with #2000 (diameter: 200 mm, thickness: 280 μm) using a mounter (in Examples 1 to 5 and Comparative Example 4, trade name: "Adwill RAD-2700", manufactured by LINTEC Corporation; in Comparative Examples 1 to 3, trade name: "Adwill RAD-3600 F/12", manufactured by LINTEC Corporation) while heating was performed at 70°C; thus, a silicon wafer with protective film was obtained. In Comparative Examples 1 to 3, the remaining release sheet was peeled off after the film for forming a protective film was attached.
Subsequently, the silicon wafer with protective film was introduced into an environment of 130°C for 2 hours to completely cure the protective film. After that, only in Comparative Examples 1 to 3, a dicing tape (trade name: "Adwill D-676H", manufactured by LINTEC Corporation) was attached to the side of the exposed protective film.
Then, the silicon wafer with protective film was diced to a size of 3 mm × 3 mm using a dicing apparatus (product name: "DFD 651", manufactured by DISCO corporation); thus, semiconductor chips with protective film were obtained.

The results of measurement and evaluation by the following method for the properties of the (composite) sheet for forming a protective film and the semiconductor chip with protective film fabricated in the above manner are shown in Table 2.

The value of "The content of component (C) in film for forming a protective film (unit: volume%)" in Table 2 indicates the proportion of the calculated volume of the component (C) to the sum of the calculated volumes, which calculated volume is calculated from the specific gravity and the blend mass (effective component ratio) of the components (A) to (E), which are the source materials that form the film for forming a protective film.

(1) Method for measuring the thermal conductivity of the protective film

One release sheet of the film for forming a protective film fabricated in Examples and Comparative Examples was peeled off and the film for forming a protective film was introduced into an environment of 130°C for 2 hours to completely cure the protective film, and then the other release sheet was peeled off and the thermal diffusivity of the single body of the protective film was measured with a thermal diffusivity and thermal conductivity measurement apparatus (trade name: "ai-Phase Mobile lu", manufactured by ai-Phase Co., Ltd.) and the thermal conductivity was calculated by the following Calculation Formula (1). The specific heat of the single body of the protective film was calculated by the DSC method, and the density was calculated by the Archimedes method.

$$\text{Calculation Formula (1): Thermal conductivity (W/m·K)} = \text{Thermal diffusivity} \times \text{Density} \times \text{Specific heat}$$

(2) Gloss value of the wafer (chip) with protective film

The (composite) sheet for forming a protective film from which the release sheet had been peeled off was attached onto the ground surface of a silicon wafer ground with #2000 (diameter: 200 mm, thickness: 280 $\mu$m) using a mounter (in Examples 1 to 5 and Comparative Example 4, trade name: "Adwill RAD-2700", manufactured by LINTEC Corporation; in Comparative Examples 1 to 3, trade name: "Adwill RAD-3600 F/12", manufactured by LINTEC Corporation) while heating was performed at 70°C.

Subsequently, in Examples 1 to 5 and Comparative Example 4, heating was performed at 130°C for 2 hours to cure the film for forming a protective film to form a protective film on the silicon wafer, and then the pressure sensitive adhesive sheet was peeled off.

In Comparative Examples 1 to 3, the other release sheet was peeled off, and then heating was performed at 130°C for 2 hours to cure the film for forming a protective film to form a protective film on the silicon wafer.

Then, the specular gloss at 60 degrees of the surface of the protective film was measured from the opposite side to the side where the silicon wafer was present in accordance with JIS Z 8741 using a glossmeter (product name: "VG 2000", manufactured by Nippon Denshoku Industries Co., Ltd.), and the measured value was taken as the gloss value of the protective film.

(3) Method for evaluating the reliability

25 semiconductor chips with protective film fabricated were placed in a thermal shock apparatus (product name: "TSE-11A", manufactured by ESPEC Corp.), and one cycle consisting of "keeping at -40°C for 10 minutes and then keeping at 125°C for 10 minutes" was repeated 1,000 times.

After that, for the semiconductor chips with protective film taken out of the thermal shock apparatus, the presence or absence of lifting-off or peeling-off (in the joint portion between the semiconductor chip and the protective film) or cracks was observed by the cross-sectional observation of the semiconductor chip with protective film using a scanning ultrasonic flaw detector (product name: "Hye-Focus", manufactured by Hitachi Kenki FineTech Co., Ltd.); and one in which lifting-off, peeling-off, or cracks were seen was evaluated as NG. The reliability was evaluated by the number of semiconductor chips of NG out of the 25 semiconductor chips with protective film.

Table 2

| | Composition for forming a protective film (parts by mass)*2 | | | | | | | | | | | | The content of component (C) in composition (mass%) |
| | Component (A) | | | | Component (B) | | | Component (C1) | Component (C2) | Component (D) | Component (E) | Total | |
| | A-1 | A-2 | A-3 | A-4 | Epoxy compound | Curing agent DICY | Curing accelerator 2PH-Z | Boron nitride particles UHP-2 | Alumina particles CB-20A | Carbon black MA-600B | Silane coupling agent X-41-1056 | | |
| Example 1 | 19.0 | - | - | - | 19.0 | 0.46 | 0.46 | 10.0 | 48.8 | 1.9 | 0.38 | 100.0 | 58.8 |
| Example 2 | 19.0 | - | - | - | 19.0 | 0.46 | 0.46 | 19.6 | 39.2 | 1.9 | 0.38 | 100.0 | 58.8 |
| Example 3 | - | 19.0 | - | - | 19.0 | 0.46 | 0.46 | 19.6 | 39.2 | 1.9 | 0.38 | 100.0 | 58.8 |
| Example 4 | - | - | 19.0 | - | 19.0 | 0.46 | 0.46 | 19.6 | 39.2 | 1.9 | 0.38 | 100.0 | 58.8 |
| Example 5 | - | - | - | 19.0 | 19.0 | 0.46 | 0.46 | 19.6 | 39.2 | 1.9 | 0.38 | 100.0 | 58.8 |
| Comparative Example 1 | 19.0 | - | - | - | 19.0 | 0.46 | 0.46 | 19.6 | 39.2 | 1.9 | 0.38 | 100.0 | 58.8 |
| Comparative Example 2 | 15.7 | - | - | - | 15.7 | 0.38 | 0.38 | 0.0 | 65.9 | 1.6 | 0.31 | 100.0 | 65.9 |
| Comparative Example 3 | 8.9 | - | - | - | 8.9 | 0.21 | 0.21 | 0.0 | 80.7 | 0.91 | 0.18 | 100.0 | 80.7 |
| Comparative Example 4 | 10.3 | - | - | - | 10.3 | 0.25 | 0.25 | 19.6 | 58.0 | 1.05 | 0.21 | 100.0 | 77.6 |

*2: Effective component ratio

## Table 2 -continued

| | (Composite) sheet for forming a protective film | | Evaluation items | | |
| | Presence or absence of pressure sensitive adhesive sheet | The content of component (C) in film for forming a protective film (volume%) | Thermal conductivity (W/(m·K)) | Gloss value | Reliability (number of NGs/25) |
| Example 1 | Present | 32.4 | 1.7 | 35 | 0/25 |
| Example 2 | Present | 36.0 | 2.5 | 26 | 0/25 |
| Example 3 | Present | 36.0 | 2.5 | 33 | 0/25 |
| Example 4 | Present | 36.0 | 2.5 | 34 | 0/25 |
| Example 5 | Present | 36.0 | 2.5 | 33 | 2/25 |
| Comparative Example 1 | Absent | 36.0 | 2.5 | 2 | 0/25 |
| Comparative Example 2 | Absent | 36.0 | 1.3 | 2 | 0/25 |
| Comparative Example 3 | Absent | 55.1 | 3.8 | 1 | 25/25 |
| Comparative Example 4 | Present | 55.1 | 4.0 | 23 | 25/25 |

The protective film formed using the composite sheet for forming a protective film of Examples 1 to 5 has a high thermal conductivity and good heat dissipation properties. The gloss value of the protective film measured from the side where the wafer (chip) is present of the wafer with protective film fabricated using the composite sheet for forming a protective film is high, and it is presumed that the marking properties of the protective film are good. Furthermore, the reliability of the semiconductor chip with protective film fabricated using the composite sheet for forming a protective film is good.

On the other hand, since the sheet for forming a protective film of Comparative Examples 1 to 3 has no pressure sensitive adhesive sheet, the gloss value of the protective film measured from the side where the wafer (chip) is present of the wafer with protective film fabricated using the film for forming a protective film is low, and it is presumed that the marking properties of the protective film are less good.

For the protective film formed of the sheet for forming a protective film of Comparative Example 2, the thermal conductivity is low as compared to Examples, and the heat dissipation properties are not improved sufficiently.

For the protective film formed of the sheet for forming a protective film of Comparative Example 3, although the thermal conductivity is improved because alumina particles are contained in a large amount, the reliability of the chip with protective film manufactured using the sheet for forming a protective film is significantly reduced.

Both the thermal conductivity and the gloss value of the protective film formed of the film for forming a protective film of the composite sheet for forming a protective film of Comparative Example 4 are good; but since the content of the component (C) in the protective film is large, the reliability of the chip with protective film manufactured using the composite sheet for forming a protective film is significantly reduced.

INDUSTRIAL APPLICABILITY

The composite sheet for forming a protective film of the present invention is suitable as a material for forming a protective film that protects a back surface of a semiconductor chip.

REFERENCE NUMERALS

| 1a, 1b, 1c, 2a, 2b, 2c : | Composite sheet for forming a protective film |
| --- | --- |
| 10, 10' : | Pressure sensitive adhesive sheet |
| 11 : | Substrate |
| 11a : | Substrate side |
| 12 : | Pressure sensitive adhesive layer |
| 12a : | Cured region |
| 13 : | Energy ray shield layer |
| 20 : | Film for forming a protective film |
| 31 : | Jig adhesion layer |
| 41 : | Pressure sensitive adhesive layer for jig adhesion |

**Claims**

1. A composite sheet (1, 2) for forming a protective film (20) comprising: a pressure sensitive adhesive sheet (10) having a pressure sensitive adhesive layer (12) on a substrate (11); and a film having curability for forming a protective film formed of a composition for forming a protective film on at least part of the pressure sensitive adhesive layer (12), wherein

the composition for forming a protective film (20) comprises an inorganic filler, C, comprising metal compound particles, C2;
wherein a content of the component C is 10 to 70 mass% relative to the total amount of the composition for forming a protective film (20),
a content of the component C comprised in the film for forming the protective film (20) is 10 to 50 volume%,
**characterised in that**
the inorganic filler, C, further comprises boron nitride particles, and the average particle size of the metal compound particles, C2, is 0.35 to 0.85 times of the thickness of the film for forming the protective film (20).

2. The composite sheet (1, 2) for forming a protective film (20) according to claim 1, having a configuration in which the film for forming a protective film (20) is directly stacked on at least part of the pressure sensitive adhesive layer (12).

3. The composite sheet (1, 2) for forming a protective film (20) according to claim 1 or 2, wherein the substrate (11) is a substrate comprising a polypropylene film.

4.  The composite sheet (1, 2) for forming a protective film (20) according to any one of claims 1 to 3, wherein a content of the component C1 in the composition for forming a protective film (20) is 10 to 80 mass% relative to the total amount of the component C.

5.  The composite sheet (1, 2) for forming a protective film (20) according to any one of claims 1 to 4, wherein the composition for forming a protective film (20) further comprises a polymer component, A, and a curable component, B.

6.  The composite sheet (1, 2) for forming a protective film (20) according to claim 5, wherein the component A is an acrylic-based polymer in which a constituent unit, al, derived from an alkyl (meth)acrylate having an alkyl group having 1 to 18 carbon atoms is comprised and a content of a constituent unit derived from one or more epoxy group-containing monomer selected from an epoxy group-containing (meth)acrylic acid ester and a non-acrylic-based epoxy group-containing monomer is 0 to 20 mass%.

7.  The composite sheet (1, 2) for forming a protective film (20) according to any one of claims 1 to 6, wherein the composition for forming a protective film (20) further comprises a coloring agent, D.

8.  The composite sheet (1, 2) for forming a protective film (20) according to any one of claims 1 to 7, wherein the pressure sensitive adhesive layer (12) is a layer formed of an energy ray curable pressure sensitive adhesive composition.

9.  The composite sheet (1, 2) for forming a protective film (20) according to claim 8, having a configuration in which at least part of the pressure sensitive adhesive layer (12) has a cured region and the film for forming a protective film (20) is directly stacked on the cured region of the pressure sensitive adhesive layer (12).

10. The composite sheet (1, 2) for forming a protective film (20) according to any one of claims 1 to 9, wherein a thermal conductivity of a protective film formed by curing the film for forming a protective film (20) is 1.5 W/(m·K) or more.

11. A method for fabricating a chip with protective film (1, 2) comprising the following steps (1) to (4):

     step (1): a step of attaching the film for forming a protective film (20) of the composite sheet for forming a protective film according to any one of claims 1 to 10 to a back surface of a workpiece to obtain a workpiece equipped with the film for forming a protective film;
     step (2): a step of dicing the workpiece equipped with the film for forming a protective film;
     step (3): a step of curing the film for forming a protective film; and
     step (4): a step of picking up a diced workpiece with protective film obtained through steps (1) to (3) to obtain a chip with protective film.

**Patentansprüche**

1.  Verbundfolie (1, 2) zur Bildung eines Schutzfilms (20), umfassend: eine druckempfindliche Klebstofffolie (10), die eine druckempfindlichen Klebstoffschicht (12) auf einem Substrat (11) aufweist; und einen Film, aufweisend eine Härtbarkeit zur Bildung eines Schutzfilms, der aus einer Zusammensetzung zur Bildung eines Schutzfilms auf mindestens einem Teil der druckempfindlichen Klebstoffschicht (12) gebildet ist, wobei
    die Zusammensetzung zur Bildung eines Schutzfilms (20) einen anorganischen Füllstoff, C, umfasst, der Metallverbindungsteilchen, C2, umfasst;
    wobei ein Gehalt der Komponente C 10 bis 70 Massen-%, bezogen auf die Gesamtmenge der Zusammensetzung, zur Bildung eines Schutzfilms (20) beträgt,
    ein Gehalt der Komponente C, die in dem Film zur Bildung des Schutzfilms (20) enthalten ist, 10 bis 50 Volumen-% beträgt,
    **dadurch gekennzeichnet, dass**
    der anorganische Füllstoff C weiter Bornitridteilchen umfasst, und
    und dadurch, dass die durchschnittliche Teilchengröße der Metallverbindungsteilchen, C2, das 0,35- bis 0,85-fache der Dicke des Films zur Bildung des Schutzfilms (20) beträgt.

2.  Verbundfolie (1, 2) zur Bildung eines Schutzfilms (20) nach Anspruch 1, aufweisend eine Konfiguration, bei der die Folie zur Bildung eines Schutzfilms (20) direkt auf mindestens einen Teil der druckempfindlichen Klebstoffschicht (12) gestapelt ist.

3. Verbundfolie (1, 2) zur Bildung eines Schutzfilms (20) nach Anspruch 1 oder 2, wobei das Substrat (11) ein Substrat ist, das einen Polypropylenfilm umfasst.

4. Verbundfolie (1, 2) zur Bildung eines Schutzfilms (20) nach einem der Ansprüche 1 bis 3, wobei der Gehalt der Komponente C1 in der Zusammensetzung zur Bildung eines Schutzfilms (20) 10 bis 80 Massen-%, bezogen auf die Gesamtmenge der Komponente C, beträgt.

5. Verbundfolie (1, 2) zur Bildung eines Schutzfilms (20) nach einem der Ansprüche 1 bis 4, wobei die Zusammensetzung zur Bildung eines Schutzfilms (20) weiter eine Polymerkomponente, A, und eine härtbare Komponente, B, umfasst.

6. Verbundfolie (1, 2) zur Bildung eines Schutzfilms (20) nach Anspruch 5, wobei die Komponente A ein Polymer auf Acrylbasis ist, in dem eine konstituierende Einheit a1, die von einem Alkyl(meth)acrylat aufweisend eine Alkylgruppe aufweisend 1 bis 18 Kohlenstoffatome abgeleitet ist, umfasst ist und der Gehalt einer konstituierenden Einheit, die von einem oder mehreren epoxygruppenhaltigen Monomer(en) abgeleitet ist, ausgewählt aus einem epoxygruppenhaltigen (Meth)acrylsäureester und einem nicht acrylbasierten epoxygruppenhaltigen Monomer, 0 bis 20 Massen-% beträgt.

7. Verbundfolie (1, 2) zur Bildung eines Schutzfilms (20) nach einem der Ansprüche 1 bis 6, wobei die Zusammensetzung zur Bildung eines Schutzfilms (20) weiter ein Färbemittel, D, umfasst.

8. Verbundfolie (1, 2) zur Bildung eines Schutzfilms (20) nach einem der Ansprüche 1 bis 7, wobei die druckempfindliche Klebstoffschicht (12) eine Schicht ist, die aus einer durch Energiestrahlen härtbaren, druckempfindlichen Klebstoffzusammensetzung gebildet ist.

9. Verbundfolie (1, 2) zur Bildung eines Schutzfilms (20) nach Anspruch 8, aufweisend eine Konfiguration, bei der mindestens ein Teil der druckempfindlichen Klebstoffschicht (12) einen gehärteten Bereich aufweist und der Film zur Bildung eines Schutzfilms (20) direkt auf den gehärteten Bereich der druckempfindlichen Klebstoffschicht (12) gestapelt ist.

10. Verbundfolie (1, 2) zur Bildung eines Schutzfilms (20) nach einem der Ansprüche 1 bis 9, wobei eine Wärmeleitfähigkeit eines durch Aushärten des Films zur Bildung eines Schutzfilms (20) gebildeten Schutzfilms 1,5 W/(m-K) oder mehr beträgt.

11. Verfahren zur Herstellung eines Chips mit Schutzfilm (1, 2), umfassend die folgenden Schritte (1) bis (4):

Schritt (1): einen Schritt des Anbringens des Films zur Bildung eines Schutzfilms (20) der Verbundfolie zur Bildung eines Schutzfilms nach einem der Ansprüche 1 bis 10 an einer Rückseite eines Werkstücks, um ein mit dem Film zur Bildung eines Schutzfilms ausgestattetes Werkstück zu erhalten;
Schritt (2): einen Schritt des Zerschneidens in Würfel des mit dem Film zur Bildung eines Schutzfilms ausgestatteten Werkstücks;
Schritt (3): einen Schritt des Härtens des Films zur Bildung eines Schutzfilms; und
Schritt (4): einen Schritt des Aufnehmens eines in Würfel zerschnittenen Werkstücks mit Schutzfilm, der durch die Schritte (1) bis (3) erhalten wurde, um einen Chip mit Schutzfilm zu erhalten.

**Revendications**

1. Feuille composite (1, 2) pour former un film protecteur (20) comprenant: une feuille adhésive (10) présentant une couche adhésive (12) sur un substrat (11) ; et un film présentant un durcissement pour former un film protecteur formé d'une composition pour former un film protecteur sur au moins une partie de la couche adhésive (12), dans laquelle
la composition pour former un film protecteur (20) comprend une charge inorganique, C, comprenant des particules de composé métallique, C2 ;
dans laquelle une teneur du composant C est de 10 à 70 % en masse par rapport à la quantité totale de la composition pour former un film protecteur (20),
une teneur du composant C comprise dans le film pour former le film protecteur (20) est de 10 à 50 % en volume, **caractérisée en ce que**

la charge inorganique, C, comprend en outre des particules de nitrure de bore, et
la taille de particule moyenne des particules de composé métallique, C2, est de 0,35 à 0,85 fois l'épaisseur du film pour former le film protecteur (20).

2. Feuille composite (1, 2) pour former un film protecteur (20) selon la revendication 1, présentant une configuration dans laquelle le film pour former un film protecteur (20) est directement empilé sur au moins une partie de la couche adhésive (12).

3. Feuille composite (1, 2) pour former un film protecteur (20) selon la revendication 1 ou 2, dans laquelle le substrat (11) est un substrat comprenant un film polypropylène.

4. Feuille composite (1, 2) pour former un film protecteur (20) selon l'une quelconque des revendications 1 à 3, dans laquelle une teneur du composant C1 dans la composition pour former un film protecteur (20) est de 10 à 80 % en masse par rapport à la quantité totale du composant C.

5. Feuille composite (1, 2) pour former un film protecteur (20) selon l'une quelconque des revendications 1 à 4, dans laquelle la composition pour former un film protecteur (20) comprend en outre un composant polymère, A, et un composant durcissable, B.

6. Feuille composite (1, 2) pour former un film protecteur (20) selon la revendication 5, dans laquelle le composant A est un polymère à base d'acrylique comprenant une unité constituante, a1, dérivée d'un méth(acrylate) alkyle présentant un groupe alkyle présentant 1 à 18 atomes de carbone et une teneur d'une unité constituante dérivée d'un ou plusieurs groupes époxy contenant un monomère sélectionné à partir d'un groupe époxy contenant un ester d'acide méth(acrylique) et un groupe époxy non à base d'acrylique contenant un monomère est de 0 à 20 % en masse.

7. Feuille composite (1, 2) pour former un film protecteur (20) selon l'une quelconque des revendications 1 à 6, dans laquelle la composition pour former un film protecteur (20) comprend en outre un agent colorant, D.

8. Feuille composite (1, 2) pour former un film protecteur (20) selon l'une quelconque des revendications 1 à 7, dans laquelle la couche adhésive (12) est une couche formée d'une composition adhésive pouvant durcir sous l'effet d'un rayon énergétique.

9. Feuille composite (1, 2) pour former un film protecteur (20) selon la revendication 8, présentant une configuration dans laquelle au moins une partie de la couche adhésive (12) présente une région durcie et le film pour former un film protecteur (20) est directement empilé sur la région durcie de la couche adhésive (12).

10. Feuille composite (1, 2) pour former un film protecteur (20) selon l'une quelconque des revendications 1 à 9, dans laquelle une conductivité thermique d'un film protecteur formé par le durcissement du film pour former un film protecteur (20) est de 1,5 W/(m-K) ou plus.

11. Procédé de fabrication d'une puce avec un film protecteur (1, 2) comprenant les étapes (1) à (4) suivantes :

étape (1) : étape de fixation du film pour former un film protecteur (20) de la feuille composite pour former un film protecteur selon l'une quelconque des revendications 1 à 10 à une surface arrière d'une pièce pour obtenir une pièce équipée d'un film pour former un film protecteur ;
étape (2) : étape de découpe de la pièce équipée du film pour former un film protecteur ;
étape (3) : étape de durcissement du film pour former un film protecteur ; et
étape (4) : étape de sélection d'une pièce découpée avec un film protecteur obtenue par l'intermédiaire des étapes (1) à (3) pour obtenir une puce avec un film protecteur.

# FIG. 1

(a)

(b)

(c)

# FIG. 2

(a)

(b)

(c)

**EP 2 979 864 B1**

## REFERENCES CITED IN THE DESCRIPTION

### Patent documents cited in the description

- JP 2002280329 A
- JP 2012158653 A
- US 2012025399 A1